# FASCICULE DE BREVET EUROPEEN

(11) **EP 3 107 125 B1**
(45) Date de publication et mention de la délivrance du brevet: **08.01.2020**
(21) Numéro de dépôt: 16174868.6
(22) Date de dépôt: 16.06.2016
(51) Int. Cl.: H01L 29/66, H01L 21/8234, H01L 21/8238, H01L 21/02, H01L 21/311, H01L 21/3115, H01L 29/786

(54) **PROCÉDÉ DE FORMATION DES ESPACEURS D'UNE GRILLE D'UN TRANSISTOR**
VERFAHREN ZUR BILDUNG VON ABSTANDHALTERN EINES GATES EINES TRANSISTORS
METHOD FOR FORMING SPACERS OF A TRANSISTOR GATE

(30) Priorité: 19.06.2015 FR 1555667
(43) Date de publication de la demande: 21.12.2016
(73) Titulaire: COMMISSARIAT À L'ÉNERGIE ATOMIQUE ET AUX ÉNERGIES ALTERNATIVES, 75015 Paris (FR)
(72) Inventeur: POSSEME, Nicolas, 38360 SASSENAGE (FR)
(74) Mandataire: Hautier, Nicolas

(56) Documents cités:
- EP-A1- 2 750 170
- US-A1- 2010 099 263
- US-A1- 2014 273 292
- US-A1- 2014 273 461
- US-B1- 6 335 535

## Description

### DOMAINE TECHNIQUE DE L'INVENTION

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Une innovation très importante qui remonte aux années soixante-dix, et qui est toujours utilisée, consiste à réaliser les transistors MOSFET à l'aide d'une technique dans laquelle les électrodes de source et de drain sont auto alignés sur celles de grille et ne nécessitent donc pas d'opération de photogravure pour leur définition. Combiné avec l'utilisation de grilles en silicium polycristallin, ce sont les grilles elles-mêmes, réalisées en premier, qui servent de masque lors du dopage des zones de source et drain des transistors.

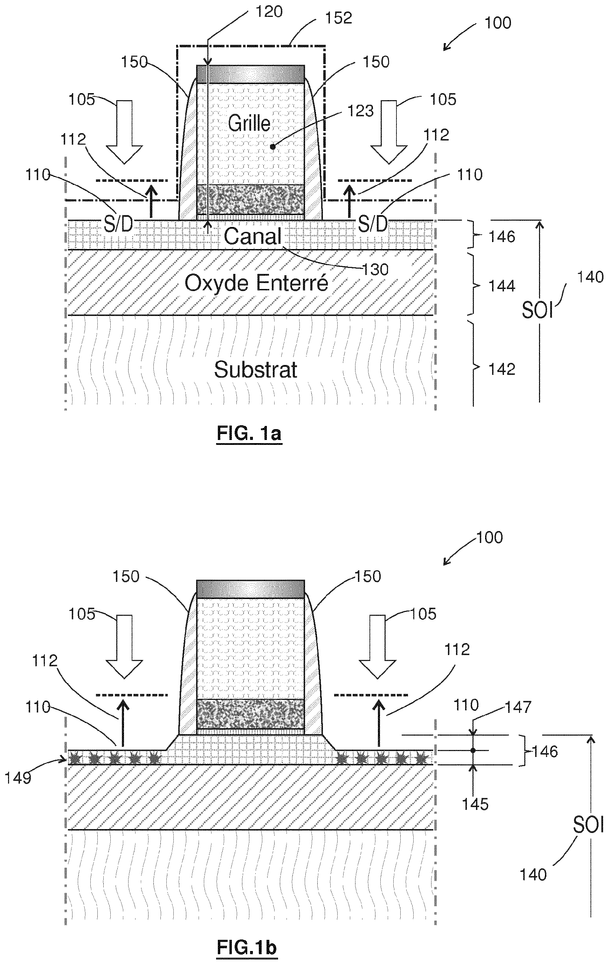

La **figure 1a** est une vue en coupe d'un exemple de ce type de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est toujours constituée de silicium polycristallin 123. La formation des zones de source et drain se fait typiquement par implantation ionique 105 de dopants dans les zones 110, la grille 120 servant de masque comme mentionné ci-dessus, empêchant ainsi le dopage de la zone du transistor MOSFET dans laquelle, en fonction des tensions appliquées sur la grille, va pouvoir se développer le canal 130 de conduction entre source et drain.

La technique de base, très brièvement décrite ci-dessus, bien connue de l'homme du métier ainsi que de nombreuses variantes, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique largement utilisée actuellement consiste à fabriquer les circuits intégrés en partant de substrats élaborés 140 de type silicium sur isolant, désignés par leur acronyme SOI, de l'anglais « silicon on insulator». Le substrat élaboré SOI est caractérisé par la présence d'une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 144. En ce qui concerne l'invention, on retiendra seulement que la couche superficielle de silicium monocristallin 146 peut être contrôlée précisément en épaisseur et en dopage. En particulier, il est avantageux pour les performances des transistors que le canal 130 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 146 est très mince ce qui n'est pas sans inconvénient par ailleurs comme on le verra dans la description de l'invention. Ce type de transistor est ainsi désigné par l'acronyme FDSOI.

Un perfectionnement de la technique de base d'auto alignement qui a été universellement adopté consiste en la formation d'espaceurs 150 sur les flancs de la grille. Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait évidemment rectangulaire.

Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, dans le cadre de la présente invention, et comme cela sera détaillé par la suite, il a été constaté que plusieurs types de défaut tels que ceux mentionnés ci-dessous apparaissent lors de la gravure des espaceurs en utilisant l'un ou l'autre des procédés connus de gravure anisotrope.

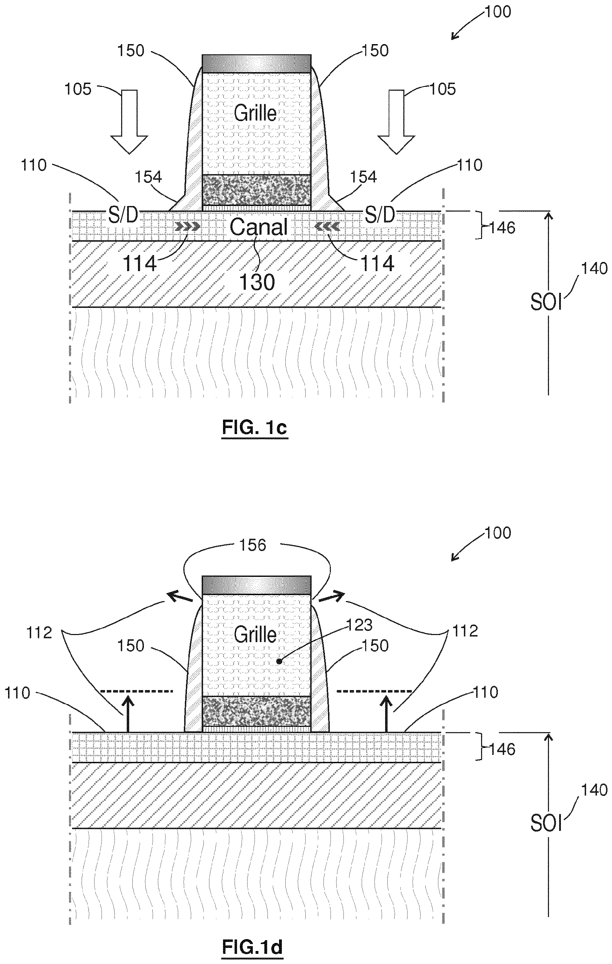

Les **figures 1b****,** **1c et 1d** illustrent chacune un type de défaut observé.

On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu le matériau préféré pour la réalisation des espaceurs, le gaz réactif est typiquement le fluorure de méthyle (CH3F) que l'on fait réagir avec le matériau à graver en introduisant également du dioxygène (O2). On forme ainsi un plasma de gravure basé sur la chimie du fluor et souvent désigné par ses constituants : CH3F/O2/He. Dans ce plasma le composé fluor sert à graver le nitrure de silicium tandis que l'oxygène permet de limiter la polymérisation du fluorure de méthyle et sert également à oxyder le silicium lorsque ce matériau est atteint en cours de gravure. La couche d'oxyde formée sur le silicium permet de ralentir la gravure du silicium au prix cependant d'une transformation en surface de ce dernier en oxyde et donc d'une consommation superficielle de silicium. L'hélium sert de diluant pour l'oxygène.

L'avantage de ce type de gravure est qu'elle est assez anisotrope et permet de contrôler suffisamment le profil des espaceurs 150 même si l'on ne peut pas obtenir en pratique la forme rectangulaire idéale. L'inconvénient de ce type de gravure est que la sélectivité d'attaque du silicium sous-jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide fluorhydrique (HF) ou d'acide phosphorique (H3PO4) qui ont une bien meilleure sélectivité, respectivement, vis-à-vis du silicium ou de son oxyde (SiO2) mais qui ne permettent pas cependant de contrôler le profil des espaceurs puisque la gravure est essentiellement isotrope dans ce cas. On notera ici que ce type de gravure est aussi qualifié de « nettoyage humide » traduction de l'anglais « wet clean ».

On notera ici qu'il existe de nombreuses publications sur le sujet de la gravure du nitrure de silicium et/ou des espaceurs de grille en général. On pourra se référer par exemple aux brevets ou demandes de brevets américains suivants : 2003/0207585 ; 4 529 476 ; 5 786 276 et 7 288 482.

La **figure 1b** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme précédemment mentionné, la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Comme précédemment mentionné, cette dernière opération est rendue nécessaire en raison de la diminution de taille des transistors afin de pouvoir maintenir les résistances d'accès aux électrodes de source et de drain à des valeurs suffisamment faibles pour ne pas impacter le fonctionnement électrique des transistors. Une croissance à partir d'une couche de silicium partiellement ou totalement rendue amorphe va créer de nombreux défauts dans la couche formée par épitaxie.

La **figure 1c** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficiel de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 1d** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes. En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non-uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

De plus, pour certaines applications il peut être nécessaire de prévoir une couche de protection souvent à base de carbone telle un masque ou une résine photosensible (de l'anglais « photoresist ») ou thermosensible afin de protéger lors de la gravure des espaceurs des structures formées sur le substrat. Tel est par exemple le cas lors de la réalisation de transistors PMOS proches de transistors NMOS dont les espaceurs sont en cours de réalisation. Les procédés connus de gravure peuvent conduire à une forte consommation de cette couche de protection lors de la gravure des espaceurs du transistor PMOS.

### REQUETE AUXILIAIRE

D'autres solutions ont été proposées dans les documents US2014/0273292 et EP2750170. Ces solutions prévoient une étape d'implantation de la couche diélectrique pour la modifier de part et d'autre de la grille, suivie d'une étape de retrait de la couche diélectrique modifiée sélectivement aux portions non modifiées.

En pratique, il s'avère qu'avec ces solutions on constate des performances non optimales pour le transistor.

La présente invention a pour objet de proposer un procédé de formation d'espaceurs jouant pleinement leur rôle d'isolation et qui supprimerait ou limiterait au moins certains des défauts dans la réalisation de transistors, tels que la consommation ou l'altération du matériau semi-conducteur (i.e. Si, SiGe) de la couche active sous-jacente à la couche à graver, la formation de « pieds » au bas des motifs sur les flancs de la grille d'un transistor, la consommation d'une couche de protection à base de carbone etc.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation des espaceurs d'une grille d'un transistor à effet de champ, la grille étant située au-dessus d'une couche en un matériau semi-conducteur, comprenant une étape de formation d'une couche diélectrique recouvrant la grille du transistor.

Le procédé comprend, après l'étape de formation de la couche diélectrique, au moins une étape de modification de ladite couche diélectrique par mise en présence de la couche diélectrique avec un plasma comprenant des ions légers. Le plasma créé un bombardement d'ions légers anisotrope selon une direction privilégiée parallèle à des flancs de la grille, les conditions du plasma, en particulier l'énergie des ions légers et la dose implantée étant choisies de manière à modifier au moins des portions de la couche diélectrique qui sont situées sur un sommet de la grille et de part et d'autre de la grille et qui sont perpendiculaires aux flancs de la grille en conservant des portions non-modifiées de la couche diélectrique recouvrant les flancs de la grille ; les ions légers étant des ions à base d'hydrogène (H). Le procédé comprend également au moins une étape de retrait de la couche diélectrique modifiée à l'aide d'une gravure sélective de ladite couche diélectrique modifiée vis-à-vis de la couche en un matériau semi-conducteur et vis-à-vis de la couche diélectrique non modifiée.

Selon l'invention, l'étape de modification de la couche diélectrique est réalisée par mise en présence de la couche diélectrique avec un plasma formé à partir d'un mélange gazeux formé d'au moins un premier composant gazeux non carboné dont la dissociation génère lesdits ions légers et un deuxième composant gazeux comprenant au moins une espèce favorisant la dissociation du premier composant pour former lesdits ions légers, dans lequel le ratio de gaz entre le premier composant et le deuxième composant est compris entre 1 :19 et 19 :1.

Ainsi, l'étape de modification de la couche diélectrique est réalisée dans un plasma formé à partir d'un mélange gazeux formé d'au moins un premier gaz non carboné dont la dissociation génère lesdits ions à base d'hydrogène (H) et un deuxième gaz comprenant au moins une espèce favorisant la dissociation du premier composant pour former lesdits ions à base d'hydrogène (H), dans lequel le ratio entre le premier gaz et le deuxième gaz est compris entre 1 :19 et 19 :1.

Avantageusement, le rôle du premier composant est de modifier, par bombardement ionique, la structure cristalline de la couche diélectrique afin de pouvoir, par la suite, différencier la couche diélectrique initiale de la couche diélectrique modifiée. Le problème est que si nous utilisons un plasma à base uniquement d'un seul composant, de l'hydrogène (H₂), par exemple, le risque est de ne pas modifier de façon uniforme la couche diélectrique dans son épaisseur. Cela entraîne un mauvais contrôle de la profondeur réelle jusqu'à laquelle la couche modifiée présente une sélectivité significativement améliorée. Dans ce cas, la profondeur de l'implantation ionique dans la couche diélectrique n'est pas équivalente à l'épaisseur de la couche diélectrique modifiée dont la sélectivité est significativement améliorée et qui sera gravée à la suite du bombardement.

L'ajout d'un deuxième composant agissant avantageusement comme un gaz de dissociation (tel que l'argon, l'hélium, le xénon, l'azote), permet de faciliter la dissociation du premier composant et par ce biais, de favoriser l'implantation dudit premier composant dissocié dans la couche diélectrique, sous forme d'ions légers. La dose implantée est donc plus élevée sans pour autant avoir besoin d'augmenter la profondeur maximale d'implantation.

Il est donc important de trouver un juste ratio entre la teneur en premier composant et en deuxième composant dans le plasma destiné à modifier la couche diélectrique.

Selon l'invention, le ratio de gaz entre le premier composant et le deuxième composant est supérieur à 1:19 et inférieur à 19 :1.

Un ratio inférieur, ce qui serait le cas si l'on réduit le débit du premier gaz, aurait pour conséquence de limiter l'efficacité de la modification du film diélectrique.

Un ratio supérieur, ce qui serait le cas si l'on augmente le débit du premier gaz, aurait pour conséquence de limiter l'efficacité du deuxième gaz en termes de dissociation.

Selon l'invention, ledit ratio est compris entre 1 :19 et 19 :1. De préférence, ledit ratio est compris entre 1 :9 et 9 :1. De préférence, ledit ratio est compris entre 1 :5 et 5 :1.

Dans la présente demande de brevet un ratio entre deux composants gazeux est un ratio portant sur les débits respectifs d'introduction des composants dans l'enceinte du plasma, typiquement dans le réacteur plasma. Chaque débit se mesure habituellement en sccm. Typiquement un débit se mesure avec un débitmètre associé au réacteur.

Dans le cadre du développement de l'invention, il s'est avéré problématique de cibler une profondeur seuil de sélectivité de la couche diélectrique qui soit égale à la profondeur d'implantation. De cela, deux problèmes surviennent alors : soit la gravure de la couche diélectrique modifiée est incomplète nécessitant des étapes répétées de gravure jusqu'à obtenir la profondeur désirée, soit l'implantation opérée dans la couche diélectrique s'étend au-delà de la couche diélectrique entrainant de ce fait une altération de la couche sous-jacente par implantation.

Si l'homme du métier avait identifié ces problématiques il serait tout au mieux parvenu aux solutions suivantes. Selon une première alternative, l'homme du métier aurait tout au mieux augmenté la durée d'implantation pour tenter d'augmenter la dose sans pour autant augmenter la profondeur implantée. Toutefois, augmenter la durée d'implantation n'est pas une solution, car entraine une contrainte d'un point de vue industriel (une perte de temps entrainant nécessairement des coûts importants). Selon une seconde alternative, l'homme du métier aurait augmenté le débit de gaz léger, le problème est qu'une concentration trop importante de gaz dans le réacteur n'aurait pas pour résultat une profondeur d'implantation plus importante. En effet, au-delà d'une certaine proportion du premier gaz dans le plasma ce premier gaz ne se dissocie plus. La densité d'ions ions légers dans le plasma et donc la teneur en ions implantées n'augmentent plus.

En pratique, il s'avère qu'avec ces solutions la couche sous-jacente à la couche diélectrique, typiquement la couche active en matériau semi-conducteur n'est pas altérée. Les performances du transistor ne sont alors pas dégradées.

Avantageusement, l'implantation est réalisée à partir d'un plasma comprenant lesdits ions légers.

L'implantation par plasma a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100 nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30nm. Dans le cadre du développement de la présente invention, il a été remarqué que les implanteurs ne permettent alors pas d'obtenir une vitesse de gravure suffisamment constante de la couche modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur d'une couche diélectrique, typiquement comprise entre 1 et 10 nm et plus généralement entre 1 et 30 nm.

L'étape de modification réalisée à partir d'un plasma modifie la couche diélectrique de manière continue depuis la surface de la couche diélectrique et sur une épaisseur comprise entre 1 nm et 30nm et de préférence entre 1nm et 10 nm.

Selon un mode de réalisation particulièrement avantageux, l'implantation et le retrait de la couche diélectrique sont réalisées dans un même réacteur plasma. Une modification de la couche à retirer réalisée par une implantation par plasma permet ainsi d'effectuer la modification de la couche et la gravure dans une même chambre ce qui est très avantageux en termes de simplification, de temps et de coût du procédé.

De manière particulièrement avantageuse, la modification de la couche diélectrique par implantation d'ions légers, des ions à base d'hydrogène (H), permet d'améliorer considérablement la sélectivité de cette couche par rapport à la couche en un matériau semi-conducteur, typiquement du silicium. Cette implantation fait également que l'épaisseur de la couche diélectrique modifiée se grave plus rapidement que celle de la couche diélectrique non modifiée.

Ainsi, l'invention repose notamment sur le fait que le deuxième composant formant le plasma est apte à agir comme un gaz de dissociation vis-à-vis du premier composant, avantageusement à base d'hydrogène. En favorisant la dissociation du premier composant, soit de l'hydrogène, on augmente la densité d'ions hydrogène dans la phase gazeuse. Ainsi, pour une même énergie d'implantation, la densité d'hydrogène contenue dans la couche diélectrique en utilisant le procédé selon la présente invention est supérieure à celle obtenue à partir d'un plasma ne contenant que de l'hydrogène (H2).

Par ailleurs, et de manière particulièrement avantageuse, la consommation de la couche diélectrique modifiée par un nettoyage à base d'acide fluorhydrique, par exemple, est proche de la profondeur de l'implantation ionique dans ladite couche diélectrique modifiée. Ainsi, en contrôlant la profondeur d'implantation dans la couche diélectrique, on peut estimer avec une meilleure précision l'épaisseur de la couche diélectrique modifiée qui sera gravée après implantation.

De manière particulièrement avantageuse, la présente invention permet un meilleur contrôle de la modification de la couche diélectrique et notamment une meilleure estimation de l'épaisseur de la couche diélectrique modifiée, pouvant être différenciée plus fortement de la couche diélectrique initiale, grâce à une plus forte dose d'ions légers à base d'hydrogène implantés dans ladite couche diélectrique. Ainsi, le procédé selon la présente invention propose une diminution de l'énergie ionique pour une épaisseur similaire de la couche diélectrique, permettant, de manière particulièrement avantageuse, de réduire le facettage du masque dur ainsi que les dommages pouvant être générés sur l'empilement Si/SiGe.

Avantageusement, la modification de la couche diélectrique est réalisée à l'aide d'une chimie sans carbone de sorte à éviter la formation d'une couche résiduel à base de carbone qui rendrait difficile la gravure de la couche diélectrique.

La gravure consomme la couche diélectrique modifiée préférentiellement à la couche en un matériau semi-conducteur et à la couche diélectrique non modifiée. Ainsi, le risque de consommation excessive de la couche superficielle de matériau semi-conducteur est réduit voir supprimé.

De préférence, la modification de la couche diélectrique conserve une épaisseur de diélectrique non modifié sur les flancs de la grille. Cette épaisseur est conservée, au moins en partie, lors de la gravure sélective. Elle définit alors des espaceurs de grille.

L'invention permet ainsi d'obtenir des espaceurs à base d'un matériau diélectrique tout en réduisant voire en éliminant les problèmes des solutions connues et mentionnés précédemment.

L'invention s'avère particulièrement avantageuse pour la formation d'espaceurs de transistors FDSOI par exemple.

De manière également avantageuse, la modification de la couche diélectrique par implantation d'ions légers tels que l'hydrogène (H2) permet également d'améliorer la sélectivité de cette couche diélectrique modifiée par rapport à l'oxyde de la couche en un matériau semi-conducteur.

De manière facultative, le procédé peut en outre présenter au moins l'une quelconque des caractéristiques et étapes ci-dessous.

De préférence, les paramètres de l'implantation, notamment l'énergie d'implantation des ions légers issus du premier composant et la dose implantée, sont prévues de sorte que la couche diélectrique modifiée puisse être gravée de manière sélective vis-à-vis dudit matériau semi-conducteur et vis-à-vis de la couche diélectrique non modifiée.

Selon un mode de réalisation préférentiel, la gravure de la couche diélectrique est réalisée à l'aide d'une chimie sans carbone. Cela permet avantageusement d'éviter le dépôt d'une couche carbonée pouvant entraver la gravure de la couche diélectrique.

Avantageusement, le rôle du premier composant est de modifier, par bombardement ionique, la structure cristalline de la couche diélectrique afin de pouvoir, par la suite, différencier la couche diélectrique initiale de la couche diélectrique modifiée. Le problème est que si nous utilisons un plasma à base uniquement d'un seul composant, de l'hydrogène (H₂), par exemple, le risque est de ne pas modifier de façon uniforme la couche diélectrique dans son épaisseur. Cela entraîne un mauvais contrôle de la profondeur réelle de la couche diélectrique modifiée. Dans ce cas, la profondeur de l'implantation ionique dans la couche diélectrique n'est pas équivalente à l'épaisseur de la couche diélectrique modifiée qui sera gravée à la suite du bombardement. Par ailleurs, si la dose implantée d'hydrogène n'est pas suffisante alors cela entraîne également une non-uniformité de l'espèce implantée dans la couche diélectrique, entrainant de ce fait un mauvais contrôle de la profondeur réelle de la couche diélectrique modifiée.

L'ajout d'un deuxième composant agissant avantageusement comme un gaz de dissociation (tel que l'argon, l'hélium, le xénon, l'azote), permet de faciliter la dissociation du premier composant et par ce biais, de favoriser l'implantation dudit premier composant dissocié dans la couche diélectrique, sous forme d'ions légers.

Il est donc important de trouver un juste ratio entre la teneur en premier composant et en deuxième composant dans le plasma destiné à modifier la couche diélectrique. Avantageusement, le ratio de gaz entre le premier composant et le deuxième composant est supérieur à 1:9 et inférieur à 9:1.

Selon un mode de réalisation préféré, le premier composant est choisi parmi l'hydrogène (H2), le nitrure de silicium (SiH4), le nitrure d'hydrogène (NH3) ou le bromure d'hydrogène (HBr).

Selon un mode de réalisation préféré, le deuxième composant est choisi parmi l'hélium (He), l'azote (N2), l'argon (Ar) ou le xénon (Xe).

Selon un mode de réalisation préféré, lors de l'étape de modification de ladite couche diélectrique l'intégralité de la couche diélectrique située sur le sommet de la grille et de part et d'autre de la grille est modifiée.

Selon un mode de réalisation préféré, lors de l'étape de modification de ladite couche diélectrique la couche diélectrique située sur les flancs de la grille n'est pas modifiée.

Selon un mode de réalisation préféré, lors de l'étape de retrait l'intégralité de la couche diélectrique située sur le sommet de la grille et de part et d'autre de la grille est retirée par gravure.

De manière particulièrement avantageuse, la couche diélectrique est formée d'un ou plusieurs matériaux diélectriques dont la constante diélectrique k est inférieure ou égale à 8 et de préférence inférieure ou égale à 7. Ainsi, la présente invention n'est pas limitée à une couche diélectrique formée à base de nitrure. La présente invention n'est, par ailleurs, pas non plus limitée à une couche diélectrique de nitrure de silicium (SiN). La présente invention s'étend avantageusement à tout espaceur comprenant un matériau diélectrique à faible permittivité k (dit « Low-k » en anglais. Selon un mode de réalisation, la couche diélectrique comprend un matériau présentant une constante diélectrique inférieure à 4 et de préférence inférieure à 3.1 et de préférence inférieure ou égale à 2.

La couche diélectrique est une couche à base de silicium (Si). Le matériau de la couche diélectrique est pris parmi: le SiCO, le SiC, le SiCN, le SiOCN, le SiCBN, et le SiOCH.

Selon un mode de réalisation, la couche diélectrique est une couche non-poreuse.

Selon un autre mode de réalisation, la couche diélectrique est une couche poreuse. Dans le cadre de la présente invention, on désigne par couche poreuse, une couche dont la présence de vide dans le film est supérieure à 5% et de préférence comprise entre 5 et 10%.

Selon un exemple, qui n'est pas couvert par les revendications, la couche diélectrique est en nitrure de silicium et l'étape de formation de la couche diélectrique comprend une étape de dépôt de la couche diélectrique au cours de laquelle on effectue suivie d'une étape de réduction de la constante diélectrique de la couche diélectrique. Avantageusement, l'étape de réduction de la constante diélectrique de la couche diélectrique comprend l'introduction d'une porosité dans la couche diélectrique. Selon un autre exemple, qui n'est pas couvert par les revendications, la couche diélectrique est en nitrure de silicium et l'étape de formation de la couche diélectrique comprend l'introduction de précurseurs dans la couche diélectrique en cours de dépôt de dépôt formation de précurseurs.

Dans ces exemples, la couche diélectrique est une couche à base de nitrure de silicium et les précurseurs sont choisis de manière à former des liaisons réduisant la polarisabilité de la couche diélectrique. Ces précurseurs sont choisis de manière à générer des liaisons moins polaires que le nitrure de silicium, telles que le Si-F, le SiOF, le Si-O, le C-C, le C-H, et le Si-CH3.

Préférentiellement, l'étape de modification de la couche diélectrique, réalisée à partir d'un plasma, modifie la couche diélectrique de manière continue depuis la surface de la couche diélectrique et sur une épaisseur comprise entre 1 nm (nanomètre) et 30 nm, de préférence comprise entre 1 nm et 10 nm.

Avantageusement, le débit du premier composant est compris entre 10 et 1000 sccm (centimètre cube par minute).

Avantageusement, le débit du deuxième composant est compris entre 10 et 1000 sccm.

Préférentiellement, l'étape de modification de la couche diélectrique est réalisée de sorte à fournir une puissance de polarisation ou puissance de source, à une fréquence comprise entre 100 Hz (Hertz) et 5 kHz, avec un cycle opératoire compris entre 10% et 90%.

Selon un mode de réalisation, l'étape de modification comprend la mise en présence de la couche diélectrique avec un plasma comprenant les ions légers dans un réacteur de gravure.

On entend par « ions légers » des ions provenant de matériaux dont le numéro atomique dans la classification périodique des éléments est faible. D'une façon générale tous les éléments que l'on peut implanter dans le matériau à graver, sans provoquer de dislocation de sa structure atomique telle qu'elle entraînerait une pulvérisation de ce dernier, et donc sans re-dépôt du matériau gravé sur les parois du réacteur ou les motifs en cours de gravure eux-mêmes, sont susceptibles de convenir.

De préférence, les ions légers sont pris parmi l'hydrogène (H2).

Selon un mode de réalisation, l'étape de retrait de la couche diélectrique modifiée est effectuée par gravure humide sélective à la couche en un matériau semi-conducteur. De préférence, le matériau semi-conducteur est du silicium et l'étape de retrait de la couche diélectrique modifiée est effectuée par gravure humide sélectivement au silicium (Si) et/ou à l'oxyde de silicium (SiO2). De préférence, la gravure sélective au silicium est obtenue à l'aide d'une solution à base d'acide fluorhydrique (HF) ou à l'aide d'une solution d'acide phosphorique (H3PO4) pour une couche diélectrique à base de nitrure de silicium (SiN).

Selon un autre mode de réalisation, l'étape de retrait est effectuée par gravure sèche sélective à la couche en un matériau semi-conducteur. De préférence, la couche en un matériau semi-conducteur est du silicium. De préférence, l'étape de retrait de la couche diélectrique modifiée est effectuée par gravure sèche sélective au silicium (Si) et/ou à l'oxyde de silicium (SiO2). Selon un mode de réalisation, la gravure sèche est effectuée dans un plasma formé dans une enceinte confinée à partir d'un mélange de trifluorure d'azote (NF3), d'hydrogène (H2) ou d'ammoniac (NH3) pour former de l'acide fluorhydrique (HF).

Avantageusement, la gravure sèche comprend : une étape de gravure consistant en la formation de sels solides ; une étape de sublimation des espèces solides. Ce mode de réalisation permet d'obtenir une très bonne sélectivité de la gravure de la couche diélectrique modifiée par rapport à la couche diélectrique non modifiée et au matériau semi-conducteur non modifié. En particulier, cette sélectivité de la gravure est très supérieure (typiquement un facteur 10 au moins) à celle obtenue avec une solution de HF.

De préférence, une unique étape de modification est effectuée de sorte à modifiée la couche diélectrique dans toute son épaisseur sur toutes les surfaces parallèles au plan d'un substrat sur lequel repose la grille et à ne pas modifier la couche diélectrique dans toute son épaisseur sur les surfaces parallèles à la direction privilégiée du bombardement.

Avantageusement, les ions légers comprennent des ions à base d'hydrogène (H2) pris parmi : H, H+, H2+, H3+. Selon un autre mode de réalisation, les ions légers comprennent des ions à base d'hydrogène (H2) pris parmi H, H+, H2+, H3+

Avantageusement, l'implantation est effectuée de manière à modifier toute l'épaisseur de la couche diélectrique en dehors de la couche diélectrique disposée sur les flancs de la grille. Ainsi, la gravure retire toute la couche diélectrique à l'exception d'une partie au moins de la couche diélectrique située sur les flancs de la grille.

Avantageusement, l'épaisseur de la couche diélectrique modifiée sur les flancs de la grille est nulle ou est inférieure à l'épaisseur de la couche diélectrique avant modification par implantation.

Avantageusement, l'implantation modifie la couche diélectrique depuis sa surface et jusqu'à profondeur correspondant à une partie au moins de son épaisseur. De préférence, l'implantation modifie la couche diélectrique de manière ininterrompue depuis surface.

Selon un mode de réalisation particulier, le procédé comprend une unique étape de modification effectuée de sorte à modifier la couche diélectrique dans toute son épaisseur sur toutes les surfaces parallèles au plan d'un substrat sur lequel repose la grille et à ne pas modifier la couche diélectrique dans toute son épaisseur sur les surfaces perpendiculaires à ce plan. Ces surfaces perpendiculaires à ce plan, c'est-à-dire perpendiculaire à la couche en un matériau semi-conducteur formant un canal de conduction ou au substrat massif sont typiquement parallèles aux flancs de la grille du transistor. Ainsi, suite à cette unique étape de modification, une gravure sélective de la couche diélectrique modifiée permet de retirer la couche diélectrique sur toutes les surfaces exceptées sur celles parallèles aux flancs de la grille.

Selon un autre mode de réalisation, le procédé comprend plusieurs séquences comprenant chacune une étape de modification et une étape de retrait. Au cours d'au moins l'une des étapes de modification, seule une partie de l'épaisseur de la couche diélectrique est modifiée. Avantageusement, les séquences sont répétées jusqu'à disparition de la couche diélectrique sur toutes les surfaces parallèles au plan d'un substrat sur lequel repose la grille. Seules les faces parallèles aux flancs de la grille conservent une épaisseur de diélectrique, cette épaisseur n'ayant pas fait l'objet de modification par implantation.

Selon un mode de réalisation avantageux, la couche diélectrique est disposée directement au contact de la couche en un matériau semi-conducteur. De préférence la couche diélectrique est disposée directement au contact de la grille qui est de préférence formée dans un matériau semi-conducteur.

Avantageusement, la grille du transistor est située sur un empilement de couches formant un substrat élaboré de type silicium sur isolant (SOI). De préférence, elle est disposée directement au contact de la couche formant le canal de conduction. Avantageusement, l'utilisation de l'invention avec un tel substrat SOI permet de préserver l'intégrité de la couche superficielle de très faible épaisseur qui forme le canal de conduction d'un transistor formé à partir d'un substrat SOI.

Avantageusement, le matériau semi-conducteur est du silicium. Avantageusement, la gravure est sélective à l'oxyde de silicium (SiO2). Le matériau semi-conducteur peut également être du germanium (Ge) ou du silicium-germanium SiGe. L'étape de retrait de la couche diélectrique modifiée est effectuée par gravure humide sélectivement au Ge ou au SiGe ou et/ou à de l'oxyde de SiGe ou de l'oxyde de Ge.

Selon un mode de réalisation, le transistor est un transistor de type FDSOI. De préférence, le procédé comprend une étape de retrait complet de la couche diélectrique en dehors des flancs et de part et d'autre de la grille pour mettre à nu la couche en un matériau semi-conducteur et une étape de formation de zones de source drain à partir de la couche en un matériau semi-conducteur, par exemple par épitaxie.

Un autre aspect de la présente invention concerne un procédé de gravure d'une couche diélectrique sélectivement à du silicium (Si) et/ou à de l'oxyde de silicium (SiO2) comprenant :
- au moins une étape de modification de tout ou partie de la couche diélectrique par implantation d'ions légers tels que l'hydrogène (H2) au sein de la couche diélectrique pour former une couche diélectrique modifiée;
- au moins une étape de retrait de la couche diélectrique modifiée à l'aide d'une gravure sélective de la couche diélectrique modifiée vis-à-vis du silicium (Si) et/ou de l'oxyde de silicium (SiO2).

Avantageusement, l'implantation en particulier son énergie, la concentration et la nature des ions légers, la dose utilisée et la durée du procédé d'implantation, sont prévues de sorte que la couche diélectrique modifiée puisse être gravée de manière sélective vis-à-vis du reste de la couche diélectrique, c'est-à-dire à la couche diélectrique non modifiée.

Avantageusement, la modification de la couche diélectrique de silicium par implantation d'hydrogène (H2) permet d'améliorer la sélectivité de cette couche par rapport au silicium et/ou à l'oxyde de silicium.

De préférence, la gravure est obtenue, par exemple, à l'aide d'une solution à base d'acide phosphorique (H3PO4) pour une couche diélectrique 152 à base de nitrure de silicium ou à l'aide d'une solution à base d'acide fluorhydrique (HF).

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURE 1a à 1d montrent, d'une part, une vue en coupe d'un exemple de transistor MOSFET de type FDSOI en cours de réalisation et, d'autre part, illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
Les FIGURES 2a à 2d illustrent les étapes d'un exemple de procédé selon l'invention appliqué à la réalisation de transistors de type FDSOI.
La FIGURE 3 illustre les profils d'implantation ionique obtenus pour différentes espèces dopantes dans une couche de nitrure de silicon, avec une énergie de 300 eV.
Les FIGURES 4a, 4b et 4c illustre un mode de réalisation où une couche diélectrique 152, formée sur un substrat 142, est modifiée puis retirée par gravure en utilisant un procédé selon l'art antérieur.
Les FIGURES 5a, 5b et 5c illustre un mode de réalisation où une couche diélectrique 152, formée sur un substrat 142, est modifiée puis retirée par gravure plasma en utilisant un procédé selon un exemple de réalisation de l'invention.
La FIGURE 6 résume les étapes d'un exemple de procédé de l'invention destinées à former des espaceurs et qui n'induisent pas ou tout au moins limitent les défauts décrits dans les figures 1b à 1d.
La FIGURE 7 donne l'épaisseur de la couche diélectrique modifiée en fonction de la tension de polarisation (bias) en volts pour un graveur de type ICP.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte » ou « sous-jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

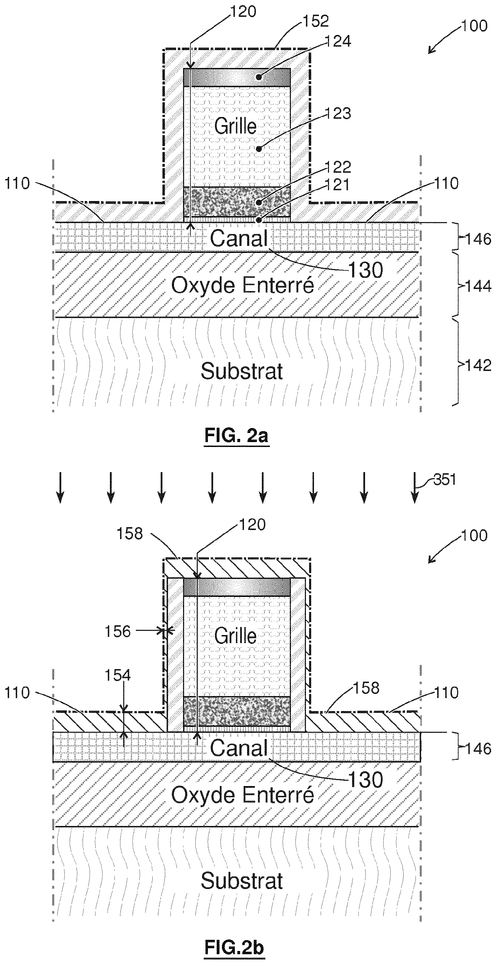

Les **figures 2a à 2d** décrivent les étapes d'un exemple détaillé d'un procédé selon l'invention appliqué à la réalisation de transistors de type FDSOI. Les principes de ces étapes peuvent également s'appliquer à la formation d'espaceurs sur les flancs d'une grille d'un autre type de transistor.

La **figure 2a** illustre l'étape de dépôt d'une couche diélectrique 152, d'épaisseur préférentiellement sensiblement uniforme, sur toutes les surfaces, verticales et horizontales, des dispositifs en cours de fabrication. Cette étape, se fait de préférence à l'aide d'une méthode de dépôt dite LPCVD, acronyme de l'anglais « low pressure chemical vapor déposition », c'est-à-dire « dépôt chimique en phase vapeur à faible pression ». Ce type de dépôt qui se pratique à pression sous atmosphérique permet en effet un dépôt uniforme sur toutes les surfaces quelle que soit leur orientation.

Quoi que cela ne soit pas nécessaire à la compréhension du procédé de l'invention on notera que l'électrode de grille est dans cet exemple composée à ce stade du procédé de plusieurs couches pour certains types de transistors. Outre la couche de silicium polycristallin 123, on retrouve dans l'empilement des couches formant la grille 120 tout d'abord la mince couche isolante d'oxyde de grille 121 à travers laquelle un champ électrique va pouvoir se développer pour créer le canal 130 de conduction sous-jacent entre source et drain quand une tension électrique suffisante est appliquée sur la grille. Dans les transistors MOSFET les plus récents il est mis en œuvre une technologie qualifiée du vocable anglais de « high-k/metal gate » c'est-à-dire que la couche isolante 121 est faite d'un matériau isolant à haute permittivité (high-k) couverte par une grille métallique (metal gate) représentée par la couche 122. Cette technologie a été développée notamment pour réduire les courants de fuite à travers la grille qui devenaient beaucoup trop importants en raison de la diminution de l'épaisseur de la couche isolante 121 jusqu'à des dimensions atomiques. À ce stade, l'empilement de couches de la grille comprend aussi un masque dur 124 de protection qui sera enlevé ultérieurement pour permettre la reprise de contact sur cette électrode. Ce masque dur, qui reste en place après gravure de la grille, est typiquement fait d'oxyde de silicium (SiO2). Son rôle est de protéger le sommet de la grille de tout dommage lors de la gravure des espaceurs.

De préférence, la couche isolante 121 est disposée au contact de la couche 146 en un matériau semi-conducteur, formant le canal de conduction. De préférence, la couche 122 est disposée au contact de la couche 121. De préférence, la couche 123 est disposée directement au contact de l'oxyde de grille formée par la couche 121, si la couche 122 est absente ou est disposée directement au contact de la couche 122. De préférence, la couche diélectrique 152 est disposée directement au contact de la couche 123 au niveau des flancs de la grille. De préférence, la couche diélectrique 152 est disposée directement au contact de la couche 146 en un matériau semi-conducteur destinée à former le canal de conduction.

Selon un mode de réalisation, la couche diélectrique 152 est à base de nitrure. Selon un mode de réalisation, la couche diélectrique 152 de nitrure a une épaisseur comprise entre 5 et 20 nm, et typiquement de l'ordre de 10 nm. Selon un autre exemple, qui n'est pas couvert par les revendications, la couche diélectrique 152 est à base de nitrure de silicium (SiN).
Selon un autre mode de réalisation, la couche diélectrique 152 comprend un matériau diélectrique à faible permittivité k (ou à faible constante diélectrique k), avec de préférence k inférieur ou égal à 7. Ainsi, la présente invention n'est pas limitée à une couche diélectrique formée à base de nitrure.

La présente invention s'étend avantageusement à tout espaceur comprenant un matériau diélectrique à faible permittivité k (dit « low-k » en anglais). On entend par « permittivité d'un matériau », au niveau microscopique, la polarisabilité électrique des molécules ou atomes constituant ledit matériau. La permittivité d'un matériau est une grandeur tensorielle (la réponse du matériau peut dépendre de l'orientation des axes cristallographiques du matériau), qui se réduit à un scalaire dans les milieux isotropes. La constante diélectrique est notée k dans le domaine des circuits intégrés et des semi-conducteurs, par exemple. Les matériaux dits « low-k » sont des diélectriques à faible permittivité. Ils sont utilisés comme isolants entre les interconnexions métalliques pour diminuer le couplage entre celles-ci.

Dans un mode de réalisation, la couche diélectrique 152 présente ou comprend un matériau présentant une constante diélectrique inférieure à 4 et de préférence inférieure à 3.1 et de préférence inférieure ou égale à 2, ce qui permet ainsi de réduire la capacité parasite pour éventuellement améliorer la performance du transistor. Selon l'invention, le matériau de la couche diélectrique 152 est pris parmi : le SiCO, le SiC, le SiCN, le SiOCN, le SiCBN, et le SiOCH. Cela permet de réduire la capacité parasite et d'améliorer en conséquence la performance du transistor.

De manière préférentielle mais uniquement facultative, le procédé de l'invention comprend une étape facultative de réduction de la constante diélectrique de la couche diélectrique 152. Selon un mode de réalisation avantageux, la réduction de la constante diélectrique est obtenue lors de l'étape de dépôt de la couche diélectrique 152.

Selon un mode de réalisation, la réduction de la constante diélectrique comprend l'introduction dans la couche diélectrique 152 en formation de précurseurs qui forment des liaisons réduisant la polarisabilité de la couche diélectrique 152. Ces précurseurs sont choisis de manière à générer des liaisons moins polaires que le nitrure de silicium, telles que le Si-F, le SiOF, le Si-O, le C-C, le C-H, et le Si-CH3.

Selon un autre mode de réalisation, alternatif ou combinable au précédent, la réduction de la constante diélectrique comprend l'introduction dans la couche diélectrique 152 en formation d'une porosité.

La **figure 2b** illustre l'étape suivante de l'invention appliquée à la réalisation de transistors FDSOI dans laquelle on procède directement à une modification 430 de la couche diélectrique 152 que l'on vient de déposer. Optionnellement, cette opération pourra avoir été précédée d'une gravure sèche conventionnelle de type CH3F/O2/He.

L'étape de modification 430 de la couche diélectrique 152 telle que déposée, ou de la couche restante après une première gravure conventionnelle, se fait par implantation 351 d'espèces légères également désignées ions légers. Dans le cadre de la présente invention, ces ions sont des ions à base d'hydrogène (H). Ces ions peuvent être implantés dans un matériau à graver, sans provoquer de dislocation de sa structure atomique telle qu'elle entraînerait une pulvérisation de ce dernier.

Typiquement, la modification de la couche diélectrique 152 à graver repose sur l'implantation d'espèces légères à base d'hydrogène (H) comme : H, H+, H2+, H3+.

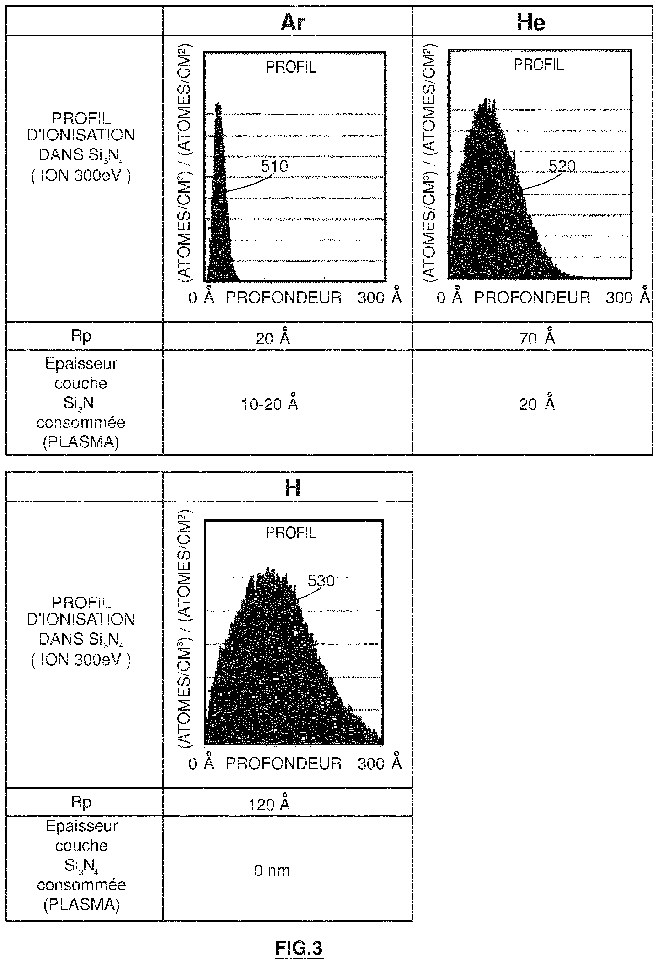

De manière particulièrement avantageuse, l'implantation d'espèces légères est favorisée par l'incorporation dans le plasma d'un deuxième composant permettant la dissociation des ions légers et donc l'augmentation de la densité d'ions légers dans le plasma et l'augmentation de la dose implantée. Ces aspects seront décrits en détail par la suite en référence aux figures 3, 4 et 5.

Avantageusement, les paramètres d'implantation, en particulier l'énergie communiquée aux ions, la durée et la dose d'implantation sont prévus de sorte que la couche diélectrique modifiée 158 puisse être gravée sélectivement par rapport à la couche 146 en un matériau semi-conducteur.

Avantageusement, ces paramètres sont également réglés de manière à ce que la couche diélectrique modifiée 158 puisse être gravée sélectivement par rapport à la portion non modifiée de la couche diélectrique 152.

Avantageusement, ces paramètres sont également réglés de manière à ce que la couche diélectrique modifiée 158 puisse être gravée sélectivement par rapport à une couche faite d'un oxyde typiquement un oxyde dudit matériau semi-conducteur, cette dernière formant par exemple une couche d'oxyde de grille. Typiquement, la gravure est sélective du matériau diélectrique modifié par implantation d'hydrogène vis-à-vis de l'oxyde de silicium.

L'implantation s'effectue par exemple dans un plasma à base d'hydrogène gazeux (H2). De manière plus générale, tous les composants gazeux, pouvant par dissociation libérer les ions légers cités précédemment, peuvent être utilisés dans le plasma. On notera ici que cette étape de modification 430 de la couche diélectrique 152 à graver peut se pratiquer de nombreuses façons différentes en adaptant toutes sortes de moyens couramment employés par l'industrie de la microélectronique. On utilise notamment des réacteurs de gravure standard dans lesquels on peut réaliser des plasmas à faible ou haute densité et où on peut contrôler l'énergie des ions pour permettre l'implantation des espèces légères ci-dessus destinées à modifier la couche à graver. On peut aussi utiliser un type de plasma dit par immersion couramment utilisé pour pratiquer une implantation d'espèces en surface d'un dispositif en cours de fabrication. Enfin, l'implantation peut aussi se faire dans un implanteur standard où l'on accélère les ions dans un champ électrique pour obtenir leur implantation dans un solide.

L'opération de modification est avantageusement très anisotrope pour la réalisation des espaceurs sur les flancs des grilles en raison de la directionnalité des ions du plasma ou de l'implanteur. Elle affecte donc préférentiellement les surfaces horizontales, c'est-à-dire toutes les surfaces parallèles au plan du substrat 142. L'épaisseur modifiée sur les surfaces horizontales 154 est ainsi nettement plus importante que sur les surfaces verticales 156 c'est-à-dire sur toutes les surfaces perpendiculaires au plan du substrat 146 élaboré, sur lequel est disposée la grille. Ce plan est perpendiculaire au plan de la coupe représentée sur les figures 2a à 2d. Le substrat 142 élaboré forme de préférence une plaque avec deux faces parallèles. Il se présente par exemple sous la forme d'un disque, d'un carré, d'un polygone, etc. La couche mince 146, la couche d'oxyde enterrée 144 et le substrat massif 142 sont disposés selon des plans parallèles. Ainsi, une surface sera qualifiée d'horizontale si elle est parallèle au plan de la couche ou des couches formant le substrat 146, sur lequel est formée la grille et une surface sera qualifiée de verticale si elle est perpendiculaire à ce même plan.

Typiquement, une épaisseur 154 de 10 nm sur les surfaces horizontales peut être modifiée au cours de cette opération. Une épaisseur 156 de la couche 152 allant de 1 à 3 nm est toutefois également modifiée sur les surfaces verticales quelles que soient les conditions du plasma. Ces surfaces verticales par rapport au plan du substrat 146 sont donc parallèles aux flancs de la grille. Les épaisseurs modifiées dépendent des conditions de mise en oeuvre, notamment des moyens employés (plasma ou implanteur) et aussi du fait que l'on désire obtenir la gravure des espaceurs en une seule étape globale de modification et de gravure ou qu'au contraire on répète ces opérations jusqu'à obtenir une gravure complète.

Ainsi, en fonction des mises en oeuvre particulières du procédé de l'invention et de l'épaisseur initiale de la couche diélectrique 152, l'étape de modification de cette couche peut affecter la totalité de cette couche où, comme représenté dans l'exemple de la figure 2b, une partie seulement de celle-ci. Dans ce cas, l'étape de modification 430 et l'étape suivante de retrait 440 de la couche modifiée décrite ci-après pourront être répétées jusqu'à enlèvement complet du matériau diélectrique de la couche diélectrique modifiée 158 sur toutes les surfaces horizontales.

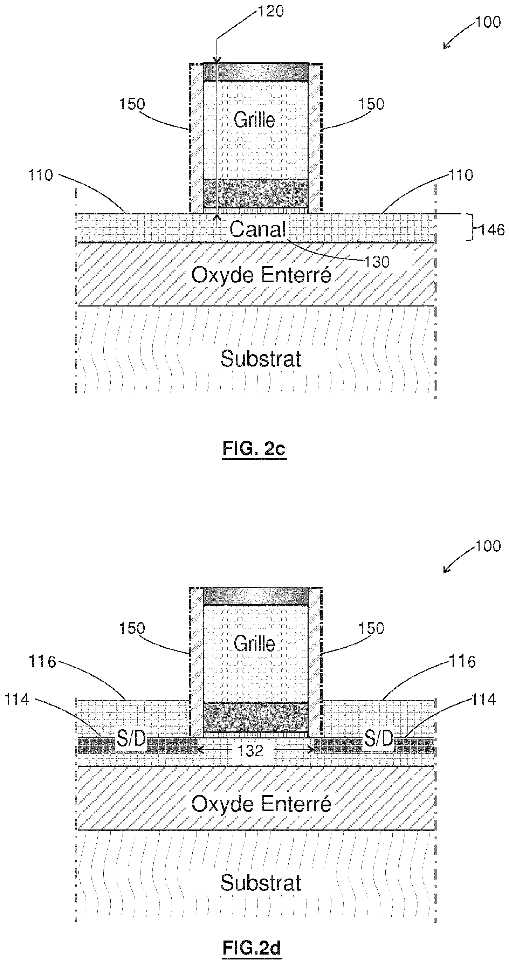

La **figure 2c** illustre le résultat final de l'étape suivante après avoir procédé à la gravure, c'est-à-dire au retrait de la couche diélectrique modifiée 158 et possiblement répété, d'une part, l'opération de modification décrite dans la figure précédente, et d'autre part, l'opération de retrait de la couche diélectrique modifiée 158.

Une méthode utilisée pour le retrait de la couche diélectrique modifiée 158 consiste, comme déjà mentionné, à utiliser une solution de gravure, par exemple, à base d'acide fluorhydrique (HF) (ou d'acide phosphorique (H3PO4) pour une couche diélectrique 152 à base de nitrure de silicium). L'arrêt de la gravure se fait sur la couche diélectrique non modifiée 152 ou sur le silicium monocristallin de la couche 146 ou encore sur le masque dur 124 au sommet des grilles. On notera ici, en référence au problème décrit dans la figure 1b, qu'il n'y a aucune consommation de silicium due à l'utilisation d'acide fluorhydrique ou d'acide phosphorique. Par ailleurs, une optimisation de l'étape de modification 430 par implantation d'espèces légères décrite ci-dessus n'entraîne qu'une modification de la couche diélectrique 152 et l'opération de gravure qui suit n'affecte donc pas le silicium sous-jacent. Ainsi, comme représenté, Il n'y a très avantageusement aucune consommation dans les zones S/D 110 de la couche de silicium 146.

À l'issue de ces opérations il ne reste donc de la couche diélectrique 152 initiale que des motifs verticaux, essentiellement sur les flancs de l'empilement de couches qui forment la grille 120. Ils constituent les espaceurs 150 de grille du transistor.

La **figure 2d** illustre la formation des zones de drain et de source d'un transistor de type FDSOI.

A l'issue de la dernière ou unique étape de retrait de la couche diélectrique modifiée 158, c'est-à-dire lorsqu'on a fini de l'enlever sur toutes les surfaces horizontales, on procède à une opération de nettoyage dite « nettoyage humide » le plus souvent qualifiée par son vocable anglais de « wet clean ». Comme on l'a déjà noté précédemment gravure humide et nettoyage humide sont des opérations similaires qui peuvent être avantageusement combinées en une seule opération.

On peut ensuite procéder à la formation des électrodes de source et de drain 110. Comme on l'a déjà mentionné, le dopage qui va délimiter source et drain et donc la longueur du canal 132 peut se faire par implantation ionique avant qu'on ne procède à une croissance épitaxiale sur ces zones afin d'augmenter leur section et diminuer leur résistance. Si le dopage est effectué avant croissance épitaxiale, comme représenté sur la figure 2d, le procédé est dit être « extension first » vocable anglais utilisé pour indiquer que les extensions (de source et de drain sous les espaceurs) sont réalisées en premier, c'est-à-dire avant croissance épitaxiale. Dans le cas contraire qui est dit être « extension last », on procède directement à l'étape de croissance épitaxiale sans dopage préalable. Le dopage des zones source/drain ne se fait qu'après croissance épitaxiale de ces zones. Dans le cas de transistors à canal de type n (nMOS), les dopants implantés sont typiquement l'arsenic (As) ou le phosphore (P). Pour les transistors à canal de type p (pMOS) les dopants sont le bore (B) ou le difluorure de bore (BF2).

Le résultat est illustré sur la figure 2d qui montre les zones source/drain dopées 114 avant croissance épitaxiale des zones source/drain surélevées 116.

La **figure 3** illustre les profils d'implantation ionique obtenus pour différentes espèces (Argon, Hélium, Hydrogène) dans une couche de nitrure de silicium, avec une énergie de 300 eV.

Afin de choisir la meilleure espèce d'ions pour modifier une couche de nitrure de silicium d'une épaisseur de l'ordre de 10-20 nm, on réalise le profil d'une gamme d'ions Rp (en anglais « Ion projected range ») à partir d'une couche de nitrure de silicium (SiN) en utilisant des conditions typiques de plasma, permettant de comparer différentes espèces d'ions, en particulier l'argon (courbe 510), l'hélium (courbe 520), l'hydrogène (courbe 530), l'hydrogène associé à un autre composant (couche 540). Le code de simulation Monte Carlo de type SRIM acronyme en anglais pour « Stopping And Range of Ions », développé par Ziegler, a été utilisé pour l'estimation et l'élaboration du profilé Rp. On considère, dans cet exemple, une couche de nitrure de silicium d'épaisseur de l'ordre de 50 nm. Il est préféré que les ions (l'argon, l'hélium, l'hydrogène, l'hydrogène associé à un autre composant), ayant une énergie cinétique de 300 eV, atteignent la surface de la plaque (correspondant à l'auto-polarisation en courant continu, mesurée à la surface de la plaque (-300 V)). Le profil Rp simulé, illustré en figure 3, est estimé entre 2 nm, 7 nm et 12 nm en utilisant, respectivement, un plasma à base d'argon 510, d'hélium et d'hydrogène 530.

Dans un plasma à base d'argon 510 ou d'hélium 520, la consommation de la couche de nitrure de silicium est estimée à 2 nm.min⁻¹ dans les conditions expérimentales de cet exemple. Par conséquent, la dégradation de la couche SiN, générée par les ions, est supprimée, car formée par le taux de pulvérisation cathodique d'argon. Lorsque que l'on utilise un plasma à base d'hélium 520, l'implantation ionique est plus profonde. Ainsi, la couche modifiée dégradée peut être ajustée, en tenant compte de la consommation de ladite couche.

Avantageusement, un plasma à base d'hydrogène 530 ne grave pas la couche de nitrure de silicium. Par conséquent, l'utilisation d'un plasma d'hydrogène offre une plus large fenêtre de procédé que l'hélium, permettant de modifier de manière plus précise et contrôlée la profondeur de la couche modifiée de nitrure de silicium. En se basant sur ces résultats, il apparait donc qu'un plasma de préférence à base d'hydrogène offre un moyen particulièrement intéressant pour un contrôle précis de la profondeur de gravure.

Par ailleurs, l'impact de la puissance de polarisation sur l'épaisseur de la couche modifiée de nitrure de silicium Si3N4, après un plasma à base d'hydrogène (avec un débit de 300sccm), d'une durée de 60 secondes, a été étudiée en utilisant un plasma à couplage capacitif en faisant varier la puissance de polarisation entre 0 et 500W et avec une pression fixée à 50 mTorr. Un nettoyage à base d'acide fluorhydrique (HF) à 1% a été effectué pour enlever la couche modifiée. Il a été observé qu'une augmentation de la puissance de polarisation entraîne une augmentation de la profondeur de la modification de la couche Si3N4, qui est corrélée à une énergie ionique plus élevée en fonction de la puissance de polarisation.

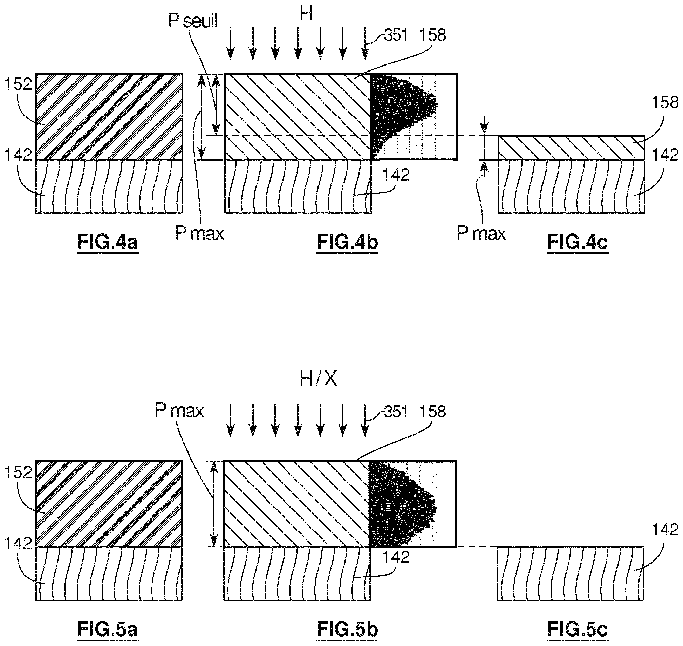

Les **figures 4a, 4b** et **4c** illustrent un mode de réalisation selon l'art antérieur où une couche diélectrique 152, formée sur un substrat 142, est modifiée puis retirée par gravure plasma à base d'hydrogène uniquement. Les **figures 5a, 5b** et **5c** illustre un mode de réalisation selon l'invention où une couche diélectrique 152, formée sur un substrat 142, est modifiée puis retirée par gravure plasma à base d'hydrogène associé à un autre composant X, jouant le rôle de gaz de dissociation.

Dans le cadre du dopant de la présente invention, il a été observé qu'il existe une valeur seuil de la dose d'hydrogène à partir de laquelle la couche diélectrique 152 est suffisamment modifiée pour être attaquée au moyen d'un nettoyage à base d'acide fluorhydrique, par exemple, ou tout au moins, pour être gravée avec une forte sélectivité vis-à-vis du matériau non modifié de la couche diélectrique 152. Si le matériau de la couche diélectrique 152 est modifié sans que la dose soit au moins égale à cette dose seuil, alors le matériau modifié de la couche diélectrique 152 ne sera pas gravé ou sera gravé avec une faible sélectivité vis-à-vis du matériau non modifié.

Or, avec une implantation plasma, les solutions connues ne permettent pas d'atteindre cette dose seuil pour la profondeur maximale implantée. En effet, au-dessus de la profondeur à laquelle la dose seuil est atteinte, il existe une profondeur d'environ 3 à 5 nm, qui est implantée mais sans pour autant présenter une dose implantée égale ou supérieure à la dose seuil.

Ce phénomène est illustré dans les figures 4a à 4c. Après une implantation à partir d'un plasma à base d'hydrogène uniquement, la couche diélectrique 152, dans cet exemple formée à base de nitrure de silicium, est implantée par des ions légers H, par exemple. Toutefois, et comme représenté sur le profil d'implantation, la couche diélectrique modifiée 158 n'est pas implantée de manière uniforme sur toute la profondeur maximale Pmax de la couche diélectrique 152. Ainsi, seule une partie de la couche diélectrique 152, sur une profondeur seuil Ps est implantée avec une dose supérieure ou égale à la dose seuil suffisante pour pouvoir autoriser une gravure sélective de la couche diélectrique modifiée 158.

Le nettoyage HF effectué après implantation ne permet alors de ne retirer que la partie de la couche diélectrique modifiée 158 comprenant une dose suffisante d'ions légers, soit la partie ayant une profondeur Pseuil. Après le nettoyage HF, il reste donc une partie (profondeur Prest=Pmax-Pseuil) de la couche diélectrique modifiée 158 comprenant une dose insuffisante d'ions légers et n'ayant pu de ce fait être retirée par un nettoyage HF. Un cycle additionnel de gravure sera alors nécessaire pour retirer la couche diélectrique modifiée 158 restante.

Afin de faire disparaître la couche résiduelle 158 sans cycle additionnel de gravure, il aurait été nécessaire d'avoir Pseuil égal à l'épaisseur de la couche diélectrique initiale 152. Pmax aurait alors été plus épaisse que l'épaisseur de la couche diélectrique initiale 152. La partie Prest aurait été contenue dans la couche 142. Cette dernière aurait donc été implantée sur une épaisseur correspondant à Prest ce qui l'aurait altéré.

Une façon d'augmenter la dose H d'ions dans la couche de nitrure de silicium est d'augmenter le temps de traitement. Le problème est la consommation de temps (> 600 s) importante nécessaire pour saturer l'hydrogène dans la couche SiN. Cette solution, de par le temps important qu'elle nécessite, ne peut donc être mise en oeuvre d'un point de vue industriel (temps de cycle élevé, aujourd'hui le temps de traitement pour la gravure d'un espaceur en nitrure étant inférieur à 60 s).

Un problème à résoudre est le retrait de la couche modifiée, puisque la couche modifiée est retirée par nettoyage HF à partir seulement d'une valeur seuil de dose d'ions légers implantée dans la couche de nitrure. Par conséquent les dommages occasionnés dans la couche de nitrure par le nettoyage HF sont sous-estimés. Ainsi, si nous ciblons un retrait de l'épaisseur de la couche de nitrure de silicium de 15 nm par un nettoyage HF 1%, le risque est d'endommager la couche sous-jacente (Si ou SiGe), puisque la profondeur d'implantation ionique sera plus profonde que 15 nm.

Avantageusement, la présente invention permet un meilleur contrôle de la modification de la couche diélectrique 152 (grâce à une dose plus élevée de H implantée dans la couche SiN) et donc par une diminution de l'énergie des ions (réduction des dommages pouvant affectés les couches sous-jacentes Si / SiGe). Les figures 5a à 5c illustrent un mode de réalisation selon la présente invention où le procédé permet de modifier la couche diélectrique 152 de telle sorte à ce que la couche diélectrique modifiée 158 soit implantée sur la profondeur Pmax avec une dose supérieure à la dose seuil, autorisant ainsi une gravure précise de la couche diélectrique modifiée 158 sur toute la profondeur Pmax.

En particulier, on observe que l'utilisation d'un deuxième composant agissant en tant que gaz de dissociation X (avec X choisi par exemple parmi : Ar, He, Xe, N2) à la chimie du premier composant H2, permet avantageusement d'augmenter la concentration des ions légers dans la phase gazeuse. Par conséquent, pour une même énergie d'implantation, la dose H implantée dans la couche SiN est supérieure à celle obtenue à partir d'un plasma à base d'un seul composant H2 seulement. Le profil Rp (associé à la profondeur d'implantation) pour une implantation à partir d'un plasma à base d'un gaz comprenant au moins un premier composant gazeux non carboné (H2) et un deuxième composant (X avec X choisi par exemple parmi : Ar, He, Xe, N2) gazeux de dissociation est proche de celui obtenu pour une implantation à base d'un seul composant H (cf. figure 3). Seule la dose implantée sera plus importante dans le cas d'un plasma comprenant un premier composant H et un deuxième composant X comparé à un plasma comprenant uniquement de l'hydrogène, par exemple. De cette manière, on peut atteindre la dose seuil d'implantation à la profondeur maximale Pmax à laquelle les ions légers sont implantés. Il n'existe alors plus d'épaisseur résiduelle implantée dont la dose est inférieure à la dose seuil. Ainsi, la consommation de la couche diélectrique modifiée 158 par le nettoyage HF est proche de la profondeur d'implantation Pmax des ions. De manière particulièrement avantageuse, on obtient une meilleure précision pour graver la couche diélectrique 152, sans toutefois endommager la couche sous-jacente.

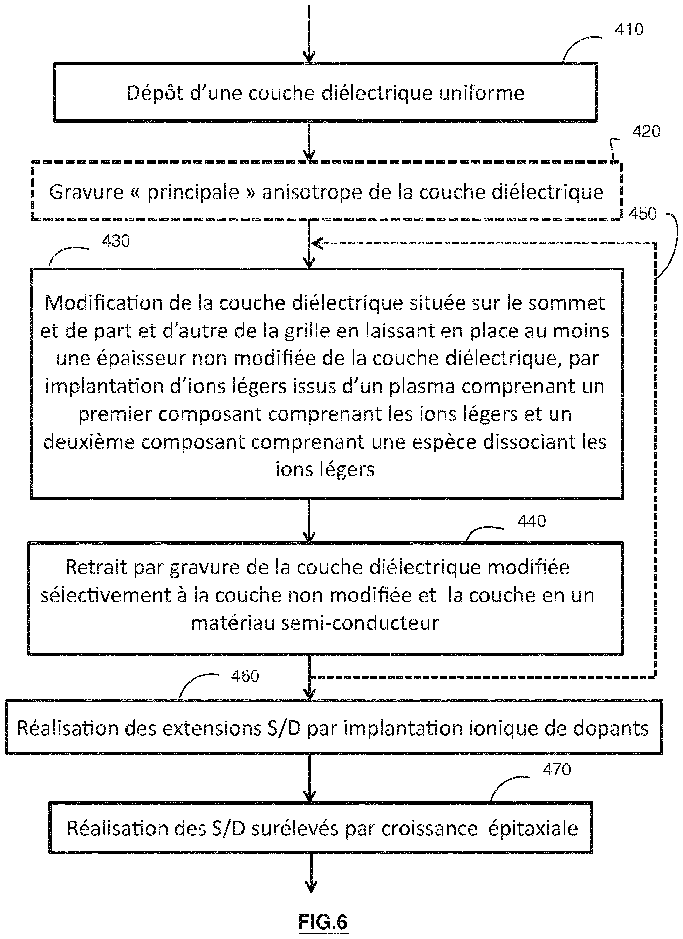

La **figure 6** résume les étapes du procédé de l'invention destinées à former des espaceurs et qui n'induisent aucun des défauts décrits notamment dans les figures 1b, 1c et 1d pour la réalisation de transistors, par exemple FDSOI.

Après dépôt 410 par LPCVD d'une couche diélectrique 152 uniforme sur toutes les surfaces des dispositifs en cours de fabrication, on procède au retrait de ladite couche diélectrique modifiée 158 sur les surfaces qui ne sont pas destinées à former les espaceurs. Ce retrait comprend plusieurs étapes, dont les étapes 430, 440 et optionnellement l'étape 420 préalable.

Ainsi, optionnellement, on procède à une gravure sèche conventionnelle anisotrope 420 de la couche diélectrique modifiée 158. Ceci est typiquement effectué dans un plasma de type CH3F/O2/He décrit précédemment. La gravure des espaceurs est ainsi, selon ce mode de réalisation optionnel et non limitatif, réalisée en deux étapes comprenant : une première étape dite de « gravure principale » et une seconde étape de finition généralement qualifiée de « sur-gravure » ou du terme anglophone de « over etching (OE) » ayant la même signification. C'est au cours de l'étape de sur-gravure (étapes 440) que l'on finira d'enlever le matériau diélectrique de la couche diélectrique modifiée 158 restant sur les surfaces horizontales, après avoir modifié (étape 430) la couche diélectrique 152 pour éviter ou limiter les problèmes décrits dans les figures 1b à 1d.

Dans le cadre de mises en oeuvre spécifiques de l'invention, on peut décider de maintenir ou non l'étape de gravure principale 420, les étapes suivantes s'appliquent alors soit sur la couche diélectrique 152 telle que déposée ou sur la couche restante après qu'une gravure principale a été préalablement effectuée comme dans le procédé standard de gravure des espaceurs.

Comme montré sur la figure 2b, l'étape suivante 430 consiste à modifier de façon anisotrope tout ou partie 154 de la couche diélectrique restante 152 par implantation d'ions légers. Avantageusement, le deuxième composant interagit sur le premier composant afin de dissocier le premier composant et favoriser la création d'ions légers, augmentant ainsi la concentration en ions H et la dose.

Suivant les applications du procédé de l'invention on pourra préférer utiliser un graveur plasma pour l'implantation plasma notamment pour les raisons suivantes : le coût de l'appareillage est moins élevé, les temps de cycle de fabrication peuvent être plus courts puisque l'étape de gravure principale 420 et celle de modification 430 de la couche diélectrique 152 peuvent alors se faire dans le même appareillage sans remise à l'air des dispositifs en cours de fabrication. On notera en particulier que l'étape de modification 430 peut se pratiquer de nombreuses façons différentes en adaptant toutes sortes de moyens couramment employés par l'industrie de la microélectronique, tel qu'à l'aide de tout type graveur, par exemple dans un réacteur ICP de l'anglais « Inductively Coupled Plasma » c'est-à-dire « plasma à couplage inductif », ou dans un réacteur de type CCP de l'anglais « Capacitive Coupled Plasma » c'est-à-dire « plasma à couplage capacitif » qui permet de contrôler l'énergie des ions. On peut aussi utiliser un type de plasma dit par immersion couramment utilisé pour pratiquer une implantation d'espèces en surface d'un dispositif en cours de fabrication.

Pour choisir les paramètres d'implantation l'homme du métier, afin de déterminer le comportement du matériau à graver dans le type de graveur plasma choisi, procédera préalablement de préférence à des essais « pleine plaque » afin d'établir des courbes de comportement. Il en déduira les paramètres de l'implantation, en particulier l'énergie et la dose d'ions, c'est-à-dire le temps d'exposition, à utiliser pour atteindre l'épaisseur voulue de matériau à modifier.

L'étape suivante 440 est celle où l'on pratique le retrait par gravure de la couche modifiée ou tout au moins de l'épaisseur modifiée de la couche diélectrique modifiée 158. Pour éviter les problèmes des procédés traditionnels de gravure des espaceurs décrits dans les figures 1b à 1d, il est nécessaire que la gravure de la couche diélectrique modifiée 158 soit la plus sélective possible par rapport au silicium notamment afin de ne pas attaquer le silicium monocristallin des zones source/drain avec les inconvénients et conséquences décrits précédemment.

Pour ce faire une gravure humide, par exemple, à base d'acide fluorhydrique (HF) (ou d'acide phosphorique (H3PO4) pour une couche diélectrique 152 à base de nitrure de silicium) qui, comme déjà mentionné, combine le retrait de la couche diélectrique modifiée 158 avec un nettoyage de la tranche contenant les dispositifs en cours de fabrication, est avantageusement utilisé. Cela simplifie le procédé et apporte un gain de temps.

L'épaisseur de la couche diélectrique modifiée 158 est typiquement comprise dans une gamme de valeurs allant de 1 nm à quelques dizaines de nm. Les temps de gravure peuvent aller de quelques secondes à quelques minutes. Ils sont évidemment directement dépendants de l'épaisseur qui a été modifiée. À titre d'exemple, pour enlever une épaisseur de 15 nm de la couche diélectrique modifiée 158, il faut de l'ordre de 60 secondes avec une solution d'acide fluorhydrique (HF) à 1%. Un temps de gravure de l'ordre de 45 secondes est requis avec de l'acide phosphorique (H3PO4).

La gravure de la couche diélectrique modifiée 158 sera également aussi sélective par rapport à l'oxyde de silicium dans d'autres applications du procédé que celle servant à la réalisation des espaceurs de transistors de type FDSOI où cela n'est pas utile. C'est notamment le cas pour pouvoir réaliser des transistors tridimensionnels de type FinFET. Une gravure sèche sélective au silicium et à son oxyde (Si/SiO2) pourra alors être aussi pratiquée pour cette étape de retrait de la couche diélectrique modifiée 158.

Une alternative est donc d'effectuer une étape du retrait par voie sèche de la couche diélectrique qui a été modifiée 158 par implantation, de préférence, d'hydrogène.

La méthode est celle décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993.

Le principe du retrait par voie sèche de la couche diélectrique modifiée 158 est identique à celui décrit dans la publication ci-dessus. La différence est que, dans le cas de l'invention, on ne grave pas de l'oxyde de silicium mais une couche diélectrique modifiée 158 ayant subie une implantation à base d'hydrogène. Le mécanisme est toutefois le même et comprend les étapes suivantes qui s'effectuent dans une chambre de réaction où l'on forme un plasma, c'est-à-dire dans un réacteur plasma. Les épaisseurs traitées sont typiquement comprises entre 1 nm et quelques dizaines de nanomètres.

Une première étape 610 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃) or avec de l'hydrogène (H2) pour former de l'acide fluorhydrique (HF).

La gravure se fait au cours d'une deuxième étape 620, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

au cours d'une opération qui dure entre quelques secondes et quelques minutes et qui s'effectue sous une pression comprise entre quelques milli Torr et quelques Torr. Plus précisément, cette opération dure entre 20 secondes et 2 minutes et s'effectue sous une pression comprise entre 500 milli Torr et 3 Torrs.

Les espèces solides qui sont formées au cours de cette opération sont ensuite sublimées 630 à une température supérieure à 100°C pendant quelques dizaines de secondes selon la réaction suivante :

(NH₄)2SiF₆ (solid) → SiF₄(g) + NH₃(g) + HF(g)

Par exemple, pour enlever 10 nm de la couche diélectrique modifiée 158, les flux de trifluorure d'azote (NF₃) et d'ammoniac (NH₃) sont respectivement de 50 sccm et de 300 sccm à 30°C pendant 45 secondes pour l'étape 620 de formation des sels qui est suivie par l'étape de sublimation 630 qui s'effectue à 180°C pendant 60 secondes.

Ce mode de réalisation permet d'obtenir une très bonne sélectivité de la gravure du nitrure modifié par rapport au nitrure non modifié et au matériau semi-conducteur non modifié. En particulier, cette sélectivité de la gravure est très supérieure (typiquement un facteur 10 au moins) à celle obtenue avec une solution de HF.

On remarquera ici qu'il existe des réacteurs de gravure permettant de réaliser une implantation, par exemple d'hydrogène, à partir d'un plasma qui peut être suivi, dans le même système, du retrait de la couche diélectrique modifiée 158 à l'aide d'une gravure sèche comme décrite ci-dessus. Ainsi, il est possible dans ce cas d'enchaîner les cycles de modification et de retrait de la couche diélectrique 152 sélectivement au Si ou SiO2, sans remise à l'air de la tranche. Ceci est une incitation supplémentaire à l'utilisation d'un réacteur de gravure pour mettre en oeuvre l'invention plutôt que d'utiliser un implanteur standard chaque fois que c'est possible.

Comme déjà mentionné les opérations de modification 430 de la couche diélectrique 152 et de retrait 440 de la couche diélectrique modifiée 158 peuvent optionnellement être répétées 450 jusqu'à disparition du matériau diélectrique de la couche diélectrique modifiée 158 sur toutes les surfaces horizontales.

Les étapes suivantes du procédé ne sont pas différentes de celles correspondantes des procédés standard où l'on réalise possiblement les extensions des zones source/drain 460 par implantation ionique de dopants avant croissance épitaxiale des source/drain surélevés 470 de transistors FDSOI.

Le tableau ci-après donne des conditions typiques de mise en oeuvre de l'étape 430 de modification de la couche diélectrique 152 dans le cas d'utilisation d'un réacteur de gravure plasma standard. Ces conditions sont largement dépendantes de l'épaisseur à modifier dans la couche diélectrique 152. Ceci n'est qu'un exemple particulier de mise en oeuvre de l'étape 430 de modification de la couche à graver. Comme déjà mentionné précédemment, d'autres moyens peuvent être utilisés pour l'implantation des espèces légères, H, servant à modifier la couche à graver. Notamment, on pourra utiliser des plasmas à faible ou haute densité ou des plasmas par immersion. Avantageusement, n'importe quel type de dispositif de gravure sèche est potentiellement utilisable et notamment ceux dit ICP de l'anglais « inductively coupled plasma » c'est-à-dire « plasma à couplage inductif » ou encore CCP de l'anglais « capacitively coupled plasma » c'est-à-dire « plasma à couplage capacitive). Ces dispositifs présentent l'avantage de pouvoir réaliser non seulement des gravures, mais également des dépôts de carbon (C) dans le même dispositif.

| | |
|---|---|
| Réacteur de gravure : | Les valeurs ci-dessous s'appliquent plus particulièrement au type de graveur ICP bien que n'importe quel type de dispositif de gravure sèche est potentiellement utilisable. |
| Épaisseur modifiée: | de 1 nm à quelques dizaines de nm, typiquement 15 nm |
| Chimie | basée sur la chimie d'un premier composant à base d'hydrogène (H2, HBr, NH3, SiH4) et d'un deuxième composant : gaz permettant la dissociation du premier composant en ions à base d'hydrogène (H) choisi parmi l'argon, l'azote, le xénon, l'hélium. |
| Débit 1^{er} composant | 10 sccm - 1000 sccm (centimètres cube par minute) |
| Débit 2^{ème} composant | 10 sccm - 1000 sccm |
| Puissance de la source : | 0 - 2000 W |
| Puissance de polarisation : | 20 V - 500 V |
| Fréquence | 100 Hz - 500 kHz |
| Cycle opératoire | 10%-90% |
| Pression: | 5 milli - 100 milli Torr |
| Température : | 10 °C - 100°C |
| Temps : | quelques secondes à quelques centaines de secondes |

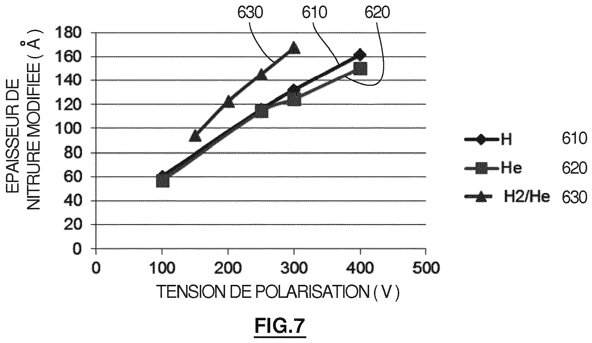

La **figure 7** donne pour le matériau standard utilisé pour former les espaceurs, c'est-à-dire le nitrure de silicium (SiN) dans cet exemple, les épaisseurs de couches modifiées obtenues en fonction de différentes conditions de mise en oeuvre de l'étape d'implantation d'espèces légères dans un réacteur de gravure plasma standard. La figure 7 donne l'épaisseur modifiée en fonction de la tension de polarisation (bias) en volts pour un graveur de type ICP et dans les conditions suivantes, pour la figure 7 : débit du premier composant de 50 sccm ; débit du deuxième composant de sccm ; puissance de la source 500 watts ; pression 10 milli Torr.
Par exemple, pour modifier une épaisseur de 10 nm de nitrure de silicium, l'énergie ionique (ou tension de polarisation) requise pour un plasma formé à partir d'un premier composant à base d'hydrogène (H2) (courbe 630) combiné à un deuxième composant à base d'hélium (He) est de 150V pour un temps = 60 s. A noter que la tendance observée est la même si l'on remplace le deuxième composant par de l'azote (N2), du xénon (Xe) ou de l'argon (Ar), par exemple. Si on utilise de l'hydrogène (H) uniquement (courbe 610) pour former le plasma, la tension de polarisation requise est alors de 200 V pendant un temps de 60 s. Avantageusement, la dissociation du premier composant par son interaction avec le deuxième composant permet d'augmenter la concentration en ions à base d'hydrogène dans le plasma, et donc d'augmenter la dose d'hydrogène implantée.
Selon un autre exemple, pour modifier une épaisseur de 16 nm de nitrure de silicium, l'énergie ionique (ou tension de polarisation) requise pour un plasma formé à partir d'un premier composant à base d'hydrogène (H2) combiné à un deuxième composant à base d'hélium (He) 630 est de 300V pour un temps = 60 s. Si on utilise de l'hydrogène (H) 610 uniquement pour former le plasma, la tension de polarisation requise est alors de 400 V pendant un temps de 60 s.

De manière particulièrement avantageuse, en réduisant l'énergie des ions pour une épaisseur similaire d'une couche de nitrure de silicium retirée par un nettoyage à base d'acide fluorhydrique (HF), on réduit le facettage du masque dur ainsi que les dommages pouvant être générés sur l'empilement Si/SiGe, comparé à un plasma formé à base d'hydrogène (H2) uniquement.

L'invention n'est pas limitée aux seuls modes et exemples de réalisation décrits ci-dessus.

## Revendications

1. Procédé de formation des espaceurs d'une grille (150) d'un transistor à effet de champ (100), la grille (150) présentant un sommet et des flancs et étant située au-dessus d'une couche (146) en un matériau semi-conducteur, comprenant une étape (410) de formation d'une couche diélectrique (152) recouvrant la grille du transistor, dans lequel la couche diélectrique (152) est en un matériau pris parmi : le SiCO, le SiC, le SiCN, le SiOCN, le SiCBN, le SiOCH, le procédé comprenant :
- après l'étape de formation de la couche diélectrique (152), au moins une étape de modification (430) de ladite couche diélectrique (152) par mise en présence de la couche diélectrique (152) avec un plasma créant un bombardement d'ions légers anisotrope selon une direction privilégiée parallèle à des flancs de la grille (120), les conditions du plasma, en particulier l'énergie des ions légers et la dose implantée étant choisies de manière à modifier au moins des portions (158) de la couche diélectrique (152) qui sont situées sur le sommet de la grille et de part et d'autre de la grille (120) et qui sont perpendiculaires aux flancs de la grille (120) en conservant des portions non-modifiées de la couche diélectrique (152) recouvrant les flancs de la grille (120) ; les ions légers étant des ions à base d'hydrogène (H) ;
- au moins une étape de retrait (440) de la couche diélectrique modifiée (158) à l'aide d'une gravure sélective de ladite couche diélectrique modifiée (158) vis-à-vis de la couche (146) en un matériau semi-conducteur et vis-à-vis de la couche diélectrique (152) non modifiée ;
**caractérisé en ce que** le plasma utilisé lors de l'étape de modification (430) de la couche diélectrique (152) est formé à partir d'un gaz comprenant au moins un premier composant gazeux non carboné dont la dissociation génère lesdits ions légers et un deuxième composant gazeux comprenant au moins une espèce favorisant la dissociation du premier composant pour former lesdits ions légers, dans lequel le ratio de gaz entre le premier composant et le deuxième composant est compris entre 1 :19 et 19 :1.

2. Procédé selon la revendication précédente dans lequel ledit ratio est compris entre 1 :9 et 9 :1 et de préférence entre 1 :5 et 5 :1.

3. Procédé selon l'une quelconque des revendications précédentes dans lequel les paramètres de l'implantation, notamment l'énergie d'implantation des ions légers issus du premier composant et la dose implantée, sont prévues de sorte que la couche diélectrique modifiée (158) puisse être gravée de manière sélective vis-à-vis de la couche (146) en un matériau semi-conducteur et vis-à-vis de la couche diélectrique (152) non modifiée.

4. Procédé selon l'une quelconque des revendications précédentes dans lequel le premier composant est choisi parmi l'hydrogène (H2), le nitrure de silicium (SiH4), le nitrure d'hydrogène (NH3) ou le bromure d'hydrogène (HBr).

5. Procédé selon l'une quelconque des revendications précédentes dans lequel le deuxième composant est choisi parmi l'hélium (He), l'azote (N2), l'argon (Ar) ou le xénon (Xe).

6. Procédé selon l'une quelconque des revendications précédentes dans lequel la couche diélectrique (152) est formée d'un ou plusieurs matériaux diélectriques dont la constante diélectrique k est inférieure ou égale à 8 et de préférence à inférieure ou égale 7 et de préférence inférieure à 4 et de préférence inférieure à 3.1 et de préférence inférieure ou égale à 2.

7. Procédé selon l'une quelconque des revendications précédentes dans lequel la couche de protection (152) est une couche poreuse.

8. Procédé selon l'une quelconque des revendications précédentes dans lequel le débit du premier composant est compris entre 10 et 1000 sccm (centimètre cube par minute) et dans lequel le débit du deuxième composant est de préférence compris entre 10 et 1000 sccm.

9. Procédé selon l'une quelconque des revendications précédentes dans lequel l'étape de retrait (440) de la couche diélectrique modifiée (158) est effectuée par gravure humide sélective à la couche (146) en un matériau semi-conducteur.

10. Procédé selon la revendication précédente dans lequel la gravure sélective au silicium est obtenue à l'aide d'une solution à base d'acide fluorhydrique (HF).

11. Procédé selon l'une quelconque des revendications 1 à 9 dans lequel l'étape de retrait (440) est effectuée par gravure sèche sélective à la couche (146) en un matériau semi-conducteur et dans lequel la gravure sèche comprend :
- une étape de gravure (620) consistant en la formation de sels solides ;
- une étape de sublimation (630) des espèces solides.

12. Procédé selon l'une quelconque des revendications précédentes comprenant une unique étape de modification (430) effectuée de sorte à modifiée la couche diélectrique (152) dans toute son épaisseur sur toutes les surfaces parallèles au plan d'un substrat (142) sur lequel repose la grille (150) et à ne pas modifier la couche diélectrique (152) dans toute son épaisseur sur les surfaces parallèles à ladite direction privilégiée.

## Patentansprüche

1. Verfahren zum Bilden der Abstandshalter eines Gates (150) eines Feldeffekttransistors (100), wobei das Gate (150) eine Spitze und Flanken aufweist und sich über einer Schicht (146) aus einem Halbleitermaterial befindet, umfassend einen Schritt (410) des Bildens einer dielektrischen Schicht (152), die das Gate des Transistors bedeckt, wobei die dielektrische Schicht (152) aus einem Material ist, ausgewählt aus: SiCO, SiC, SiCN, SiOCN, SiCBN, SiOCH, wobei das Verfahren umfasst:
- nach dem Schritt des Bildens der dielektrischen Schicht (152), mindestens einen Schritt des Modifizierens (430) der dielektrischen Schicht (152) durch Zusammenbringen der dielektrischen Schicht (152) mit einem Plasma, das einen anisotropen Beschuss leichter Ionen in einer bevorzugten Richtung parallel zu Flanken des Gates (120) erzeugt, wobei die Bedingungen des Plasmas, insbesondere die Energie der leichten Ionen und die implantierte Dosis so gewählt werden, dass mindestens Abschnitte (158) der dielektrischen Schicht (152), die sich an der Spitze des Gates und auf beiden Seiten des Gates (120) befinden und die zu den Flanken des Gates (120) senkrecht sind, unter Beibehaltung von nicht modifizierten Abschnitte der dielektrischen Schicht (152), die die Flanken des Gates (120) bedecken, modifiziert werden; wobei die leichten Ionen Ionen auf Basis von Wasserstoff (H) sind;
- mindestens einen Schritt des Entfernens (440) der modifizierten dielektrischen Schicht (158) mit Hilfe eines selektiven Ätzens der modifizierten dielektrischen Schicht (158) gegenüber der Schicht (146) aus einem Halbleitermaterial und gegenüber der nicht modifizierten dielektrische Schicht (152);
**dadurch gekennzeichnet, dass** das Plasma, das beim Schritt des Modifizierens (430) der dielektrischen Schicht (152) verwendet wird, auf Grundlage eines Gases gebildet wird, das mindestens eine erste nicht kohlenstoffhaltige gasförmige Komponente, deren Dissoziation die leichten Ionen generiert, und eine zweite gasförmige Komponente umfasst, die mindestens eine Spezies umfasst, welche die Dissoziation der ersten Komponente begünstigt, um die leichten Ionen zu bilden, wobei das Gasverhältnis zwischen der ersten Komponente und der zweiten Komponente im Bereich zwischen 1:19 und 19:1 liegt.

2. Verfahren nach dem vorstehenden Anspruch, wobei das Verhältnis im Bereich zwischen 1:9 und 9:1, und vorzugsweise zwischen 1:5 und 5:1 liegt.

3. Verfahren nach einem der vorstehenden Ansprüche, wobei die Parameter der Implantation, vor allem die Implantationsenergie der aus der ersten Komponente stammenden leichten Ionen und die implantierte Dosis so vorgesehen werden, dass die modifizierte dielektrische Schicht (158) selektiv gegenüber der Schicht (146) aus einem Halbleitermaterial und gegenüber der nicht modifizierten dielektrische Schicht (152) geätzt werden kann.

4. Verfahren nach einem der vorstehenden Ansprüche, wobei die erste Komponente ausgewählt ist aus Wasserstoff (H2), Siliziumnitrid (SiH4), Ammoniak (NH3) oder Bromwasserstoff (HBr).

5. Verfahren nach einem der vorstehenden Ansprüche, wobei die zweite Komponente ausgewählt ist aus Helium (He), Stickstoff (N2), Argon (Ar) oder Xenon (Xe).

6. Verfahren nach einem der vorstehenden Ansprüche, wobei die dielektrische Schicht (152) von einem oder mehreren dielektrischen Materialien gebildet wird, deren Dielektrizitätskonstante k kleiner oder gleich 8, und vorzugsweise kleiner oder gleich 7, und vorzugsweise kleiner als 4, und vorzugsweise kleiner als 3,1, und vorzugsweise kleiner oder gleich 2 ist.

7. Verfahren nach einem der vorstehenden Ansprüche, wobei die Schutzschicht (152) eine poröse Schicht ist.

8. Verfahren nach einem der vorstehenden Ansprüche, wobei der Durchsatz der ersten Komponente im Bereich zwischen 10 und 1000 sccm (Kubikzentimeter pro Minute) liegt, und wobei der Durchsatz der zweiten Komponente vorzugsweise im Bereich zwischen 10 und 1000 sccm liegt.

9. Verfahren nach einem der vorstehenden Ansprüche, wobei der Schritt des Entfernens (440) der modifizierten dielektrischen Schicht (158) durch Nassätzen vorgenommen wird, das in Bezug auf die Schicht (146) aus einem Halbleitermaterial selektiv ist.

10. Verfahren nach dem vorstehenden Anspruch, wobei das in Bezug auf Silizium selektive Ätzen mit Hilfe einer Lösung auf Basis von Fluorwasserstoffsäure (HF) erhalten wird.

11. Verfahren nach einem der Ansprüche 1 bis 9, wobei der Schritt des Entfernens (440) durch Trockenätzen vorgenommen wird, das in Bezug auf die Schicht (146) aus einem Halbleitermaterial selektiv ist, und wobei das Trockenätzen umfasst:
- einen Ätzschritt (620), der in der Bildung von festen Salzen besteht;
- einen Sublimationsschritt (630) der festen Spezies.

12. Verfahren nach einem der vorstehenden Ansprüche, das einen einzigen Modifikationsschritt (430) umfasst, der so vorgenommen wird, dass die dielektrische Schicht (152) an allen den Flächen, die zur Ebene eines Substrats (142), auf dem das Gate (150) ruht, parallel sind, in ihrer gesamten Dicke modifiziert wird, und die dielektrische Schicht (152) an den Flächen, die zur bevorzugten Richtung parallel sind, nicht in ihrer gesamten Dicke modifiziert wird.

## Claims

1. Method for forming spacers of a field effect (100) transistor gate (150), the gate (150) having a top and edges and being situated above a layer (146) made of a semi-conductive material, comprising a step (410) of forming a dielectric layer (152) covering the gate of the transistor, wherein the dielectric layer (152) is made of a material taken from among: SiCO, SiC, SiCN, SiOCN, SiCBN, SiOCH, the method comprising:
- after the step of forming the dielectric layer (152), at least one step of modifying (430) said dielectric layer (152) by putting in contact the dielectric layer (152) with a plasma creating a bombardment of light anisotropic ions along a favoured direction parallel to edges of the gate (120), the conditions of the plasma, in particular the energy of the light ions and the implanted dose being selected so as to modify at least portions (158) of the dielectric layer (152) which are situated on the top of the gate and on either side of the gate (120) and which are perpendicular to the edges of the gate (120) by conserving non-modified portions of the dielectric layer (152) covering the edges of the gate (120); the light ions being ions with a hydrogen base (H);
- at least one step of removing (440) the modified dielectric layer (158) using an etching of said modified dielectric layer (158) selectively with respect to the layer (146) made of a semi-conductive material and with respect to the non-modified dielectric layer (152);
**characterised in that** the plasma used during the step of modifying (430) the dielectric layer (152) is formed from a gas comprising at least one first non-carbon gaseous component of which the separation generates said light ions and a second gaseous component comprising at least one species favouring the separation of the first component to form said light ions, wherein the gas ratio between the first component and the second component is of between 1:19 and 19:1.

2. Method according to the preceding claim, wherein said ratio is of between 1:9 and 9:1 and preferably between 1:5 and 5:1.

3. Method according to any one of the preceding claims, wherein the parameters of the implantation, in particular the implantation energy of the light ions coming from the first component and the implanted dose, are provided such that the modified dielectric layer (158) can be etched selectively with respect to the layer (146) made of a semi-conductive material and with respect to the non-modified dielectric layer (152).

4. Method according to any one of the preceding claims, wherein the first component is selected from among hydrogen (H₂), silicon nitride (SiH₄), hydrogen nitride (NH₃) or hydrogen bromide (HBr).

5. Method according to any one of the preceding claims, wherein the second component is selected from among helium (He), nitrogen (N₂), argon (Ar) or xenon (Xe).

6. Method according to any one of the preceding claims, wherein the dielectric layer (152) is formed of one or more dielectric materials of which the dielectric constant k is less than or equal to 8 and preferably less than or equal to 7 and preferably less than 4 and preferably less than 3.1 and preferably less than or equal to 2.

7. Method according to any one of the preceding claims, wherein the protective layer (152) is a porous layer.

8. Method according to any one of the preceding claims, wherein the flow of the first component is of between 10 and 1000sccm (cubic centimetres per minute) and wherein the flow of the second component is preferably of between 10 and 1000sccm.

9. Method according to any one of the preceding claims, wherein the step of removing (440) the modified dielectric layer (158) is achieved by selective wet etching at the layer (146) made of a semi-conductive material.

10. Method according to the preceding claim, wherein the selective silicon etching is obtained using a hydrofluoric (HF) acid base solution.

11. Method according to any one of claims 1 to 9, wherein the removal step (440) is carried out by selective dry etching at the layer (146) made of a semi-conductive material and wherein the dry etching comprises:
- an etching step (620) consisting of the formation of solid salts;
- a step of sublimating (630) solid species.

12. Method according to any one of the preceding claims, wherein one single modification step (430) carried out so as to modify the dielectric layer (152) in all of the thickness thereof over all the surfaces parallel to the plane of a substrate (142) on which the gate (150) rests and to not modify the dielectric layer (152) in all of the thickness thereof over the surfaces parallel to said favoured direction.
